# EUROPEAN PATENT APPLICATION

(11) **EP 0 645 797 A1**
(43) Date of publication of application: **29.03.1995**
(21) Application number: 94202723.6
(22) Date of filing: 22.09.1994
(51) Int. Cl.: H01J 37/317

(54) **Electron beam lithography with background exposure in a neighbouring region**

(30) Priority: 27.09.1993 BE 9301007
(71) Applicant: PHILIPS ELECTRONICS N.V., 5621 BA Eindhoven (NL)
(72) Inventor: Van Helleputte, Henri Roger Jules Richard, NL-5656 AA Eindhoven (NL); Verheijen, Martinus Johannes, NL-5656 AA Eindhoven (NL); Binsma, Johannes Jordanus Maria, NL-5656 AA Eindhoven (NL)
(74) Representative: Bakker, Hendrik

(57) **Abstract**

A method of forming a pattern, notably a grating for semiconductor lasers, on the substrate of an integrated circuit by means of electron beam lithography. The adverse effects of the known proximity effect are prevented by additional exposure of the substrate in regions adjacent the region in which the pattern is to be written. Such additional exposure can take place with a resolution which is substantially less than that within the pattern, so that a substantial gain in time is realised relative to customary "ghost" exposure methods. Moreover, the proximity effect can thus be utilized to impose the longitudinal variation desired for laser use on the duty cycle of the grating.

## Description

The invention relates to a method of forming a pattern in a pattern region on the substrate of an integrated circuit by writing by means of a beam of electrically charged particles, the desired pattern being formed by moving the beam of given cross-section along desired contours in the pattern region on the substrate, additional exposure of the substrate being performed in locations other than the desired contours of the pattern.

The invention also relates to an integrated circuit manufactured by means of said method.

A method of this kind is described in United States Patent Specification No. 4,463,265.

During the writing of patterns on an integrated circuit by means of a beam of charged particles, (for example by means of electrons, which is referred to hereinafter as electron beam lithography), a problem is encountered in that the smallest structural dimension (the resolution) that can be achieved for the pattern to be written is dependent on the nature of the pattern to be written, and hence is variable across the pattern region. This is caused by a phenomenon which is referred to as the proximity effect. This effect occurs in that electrons having traversed the photoresist layer are scattered in the substrate situated therebelow and are thus returned to the photoresist layer, be it usually in a location adjacent the location of incidence of the primary beam. Consequently, the background exposure of the pattern to be written is increased, *i.e.* in proportion to the density of the desired patterns to be written at this area. The cited United States Patent Specification includes a clear explanation (notably in the columns 1 and 2 up to line 56) as to how the proximity effect influences the resolution of the pattern to be written by electron beam lithography. The cited document also proposes methods (column 2, line 57 as far as column 3 line 20) whereby the problem of limited resolution can be mitigated. Each of these methods has its own drawbacks as is also disclosed in the cited United States Patent Specification (column 3, lines 21-64).

In order to solve this problem, the cited US Patent Specification proposes an additional exposure of the substrate in the region in which the desired pattern is also written, be it not coincident with the lines of the pattern to be written. To this end, a complementary field pattern (reverse field pattern) is defined, being the region of the resist which is situated between the structures of the pattern to be written and which is not to be written by the primary electron beam. In addition to the exposure of the desired pattern, an additional exposure of the substrate with photoresist is executed in that the reverse field pattern is exposed. This is realised by means of a beam whose intensity and/or cross-section have been adapted to the additional exposure.

The additional exposure disclosed in the cited United States Patent Specification often follows the same contours as those of the desired pattern; this means that the additional exposure as proposed in the cited US Patent Specification requires a large amount of writing time during the formation of these patterns. Moreover, the pattern of the additional exposure differs for each pattern design. The invention aims to mitigate this drawback and to mitigate the adverse effects of the proximity effect during electron beam lithography by means of a method which requires less writing time than the known method and in which the additional exposure requires less adaptation to the pattern design.

To achieve this, the invention is characterized in that the additional exposure is performed in a region which is situated outside but adjacent the pattern region, said additional exposure being performed with a beam current which is much larger than that used for the exposure in the pattern region, and that the write pattern in the neighbouring region exhibits minimum structural dimensions which are much larger than those in the pattern region.

During the writing of the desired pattern, a given amount of electric charge is introduced into the pattern region; because of the proximity effect, this electric charge falls outside the pattern element to be written at that instant. This charge is not uniformly distributed across the pattern region, so that pattern elements at the outer limits of the pattern region will be dimensioned differently relative to the elements at the centre. The invention is based on the idea that the background exposure (by the proximity effect) can be equalized for pattern regions which are not excessively large by injecting charge into the substrate adjacent the pattern region. In conventional devices for electron beam lithography the electron source is adjusted to a fixed (optimum) brightness. Therein, the beam current is increased by increasing the beam diameter. Because no specific structural dimensions are required in the neighbouring region, it is possible to use a beam diameter and a step size therein which are many times larger than those in the pattern region, so that the desired saving in time is achieved.

The charge can be injected into the neighbouring region according to an arbitrary pattern, for as long as the charge distribution exhibits a given degree of uniformity.

An attractive embodiment of the invention is characterized in that the neighbouring region is uniformly exposed. In the case of a point-like charge distribution there is a risk that intermediate regions with residual photoresist remain after development, which intermediate regions may disturb the further processing of the circuits. This risk is avoided by uniform exposure.

A preferred version of the method in accordance with the invention is characterized in that the pattern to be written is a grating consisting of parallel lines, and that the neighbouring region is exposed in blocks whose exposure varies in a direction transversely of the line direction, the dimension of said blocks in the direction transversely of the line direction being much larger than the period of the grating. The grating lines situated directly to the side of a given block are influenced strongest by the background exposure caused by the relevant block. When a varying charge dose is injected per block, it will be achieved that the width of the lines in the grating is varied. Instead of eliminating or neutralizing the effects of the proximity effect as much as possible, the present version utilizes the proximity effect to achieve the variable duty cycle of the grating. (Duty cycle is to be understood to mean herein the ratio of the line width in the grating relative to the period of the grating). This could otherwise be achieved only by writing with a beam diameter many times smaller than the line width, so that the writing time would become many times longer. Thus, this preferred version enables the manufacture of a grating with a variable duty cycle while maintaining the gain in time.

The invention will be described in detail hereinafter with reference to the Figures; therein:
Fig. 1 shows a part of a grating formed by electron beam lithography in order to illustrate the proximity effect;
Fig. 2 shows a part of a grating formed by electron beam lithography, the doses injected into the neighbouring region being diagrammatically shown.

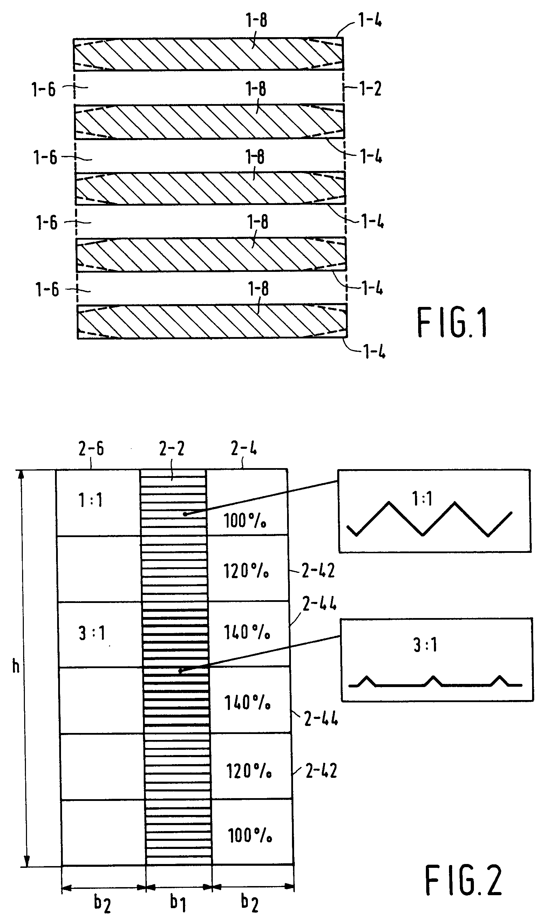

Fig. 1 shows a part 1-2 of a grating which can be inscribed by exposure of a photoresist layer on a substrate by means of an electron beam. This type of grating can be used in semiconductor lasers. In this grating the rectangular contours 1-4 are the exposed parts of the substrate, whereas the intermediate spaces 1-6 have not been exposed to electrons. Because of the proximity effect, instead of lines having a rectangular shape there will be obtained lines as denoted by the shaded areas 1-8 in Fig. 1. This effect is generally undesirable, notably when the grating is used in semiconductor lasers. A feasible solution to the problem of line distortion during the manufacture of such gratings could be to lengthen the lines to be written until the proximity effect of the ends no longer influences the desired region. This could mean a width of the desired region of approximately 5 µm, in which case it would be necessary to lengthen the lines by approximately 10 µm at each of the ends. After development of the grating thus inscribed it would be necessary to remove the regions produced by the lengthening, so that a non-distorted line pattern remains. However, this method is time-consuming (and hence expensive) because the writing time is prolonged in proportion to the line length to be written. In the given numerical example this corresponds to a five-fold prolongation. Therefore, it is advantageous to use the method of the invention as will be described in detail hereinafter with reference to Fig. 2.

Fig. 2 shows a grating 2-2, together with neighbouring regions 2-4 and 2-6. The grating has a length h of 400 µm in the longitudinal direction and comprises 2000 lines. This results in a period of the grating of 200 nm. In accordance with the invention, additional charge is injected into the neighbouring regions 2-2 and 2-4. This additional charge injection serves a dual purpose. The first object is to counteract the line distortion as described already with reference to Fig. 1. The second object is to realise a variation of the duty cycle along the grating as is often desirable for application of these gratings in semiconductor lasers (for example, see the article "A New DFB-laser Diode with Reduced Spatial Hole Burning" by G. Morthier et al, IEEE Photonics Technology Letters, Vol. 2, No. 6, pp. 388-390).

During the manufacture of the grating first the lines in the region 2-2 are written, for example with a duty cycle of 1:1. This region has a width b₁ of 5 µm. In the neighbouring regions 2-4 and 2-6 (having a width b₂ of 10 µm) charge is injected for the above purposes. Charge injection may take place homogeneously or in any other way for as long as the charge is more or less uniformly distributed across the neighbouring regions 2-4 and 2-6. In the latter case, the beam diameter (and hence the beam current with constant brightness of the electron source) can be strongly increased; if the step size of the writing process in these neighbouring regions is also strongly increased, a substantial gain in time is realised in the writing of the grating. Without loss of the advantages of this method of exposure, the exposure can be varied in large steps in the neighbouring regions in order to obtain a grating with a variable duty cycle. Fig. 2 shows an example of longitudinal dose variation from 100% (the dose required to obtain a 1:1 duty cycle) to 140% in steps of 20%, the latter dose leading to a duty cycle of 3:1. The dose variation required to achieve a given duty cycle is dependent on the desired grating; this dose variation can be readily determined experimentally (for example, by computer simulation).

In a conventional electron beam lithography machine the variation of the exposure is possible only in a limited number of discrete steps. Using such a machine, the exposure according to this version of the invention can be realised by providing the entire neighbouring regions 2-2 and 2-4 first with a dose of 100%. Subsequently, the regions 2-42 and 2-44 are written again with a dose of 20%, after which the regions 2-44 are written again with a dose of 20%. (It is alternatively possible to execute the re-exposure with an elementary exposure dose of 1%. In the exposure machine, for example 3 bits are then available for the encoding of the dose, so that 8 doses can be defined. These doses are then adjusted to 2⁰, 2¹, 2², ... 2⁸ times the elementary dose, so that 256 different doses can be formed by additional combination). This method of repeated exposure is possible in that the required reproducibility of the position of the electron beam is much less in the neighbouring regions than within the grating: for a grating period of 200 nm a positional uncertainty of 50 nm within the grating is inadmissible for re-exposure, whereas this uncertainty within the neighbouring region does not have any effect on the line shape or the duty cycle within the grating.

## Claims

1. A method of forming a pattern in a pattern region on the substrate of an integrated circuit by writing by means of a beam of electrically charged particles, the desired pattern being formed by moving the beam of given cross-section along desired contours in the pattern region on the substrate, additional exposure of the substrate being performed in locations other than the desired contours of the pattern, characterized in that the additional exposure is performed in a region which is situated outside but adjacent the pattern region, said additional exposure being performed with a beam current which is much larger than that used for the exposure in the pattern region, and that the write pattern in the neighbouring region exhibits minimum structural dimensions which are much larger than those in the pattern region.

2. A method as claimed in Claim 1, characterized in that the neighbouring region directly adjoins the pattern region.

3. A method as claimed in Claim 1, characterized in that the neighbouring region is uniformly exposed.

4. A method as claimed in Claim 1, characterized in that the pattern to be written is a grating consisting of parallel lines, and that the neighbouring region is exposed in blocks whose exposure varies in a direction transversely of the line direction, the dimension of said blocks in the direction transversely of the line direction being much larger than the period of the grating.

5. A semiconductor laser with a substrate with a substrate provided with a pattern region which constitutes a line grating which has been produced by means of a method as claimed in any one of the Claims 1 to 4.
